Europäisches Patentamt

**European Patent Office**

**Office européen des brevets**

(19)

(11) **EP 1 170 121 B1**

(12) **EUROPEAN PATENT SPECIFICATION**

(45) Date of publication and mention
of the grant of the patent:
**26.06.2002 Bulletin 2002/26**

(51) Int Cl.⁷: **B41C 1/10**, G03F 1/00

(21) Application number: **00202100.4**

(22) Date of filing: **13.06.2000**

(54) **Direct-to-plate flexographic printing plate precursor**

Direktbeschreibbarer flexographischer Druckplattenprecursor

Précurseur de plaque d'impression flexographique à impression directe

(84) Designated Contracting States:
**BE DE FR GB IT NL**

(43) Date of publication of application:
**09.01.2002 Bulletin 2002/02**

(73) Proprietor: **AGFA-GEVAERT**
**2640 Mortsel (BE)**

(72) Inventors:
• **Daems, Eddy c/o Agfa-Gevaert N.V.**
**2640 Mortsel (BE)**
• **Ruttens, Frank c/o Agfa-Gevaert N.V.**
**2640 Mortsel (BE)**
• **Damen, Guy c/o Agfa-Gevaert N.V.**
**2640 Mortsel (BE)**
• **Leenders, Luc c/o Agfa-Gevaert N.V.**
**2640 Mortsel (BE)**

(56) References cited:
EP-A- 0 741 330    EP-A- 0 908 778
US-A- 4 264 705    US-A- 5 925 500

**Description**

FIELD OF THE INVENTION

The present invention relates to a direct-to-plate flexographic printing plate precursor, more specifically to a flexographic printing plate precursor that can be developed thermally without the use of aqueous or organic processing solutions.
Furthermore the present invention relates to a method for making a direct-to-plate flexographic printing plate.

BACKGROUND OF THE INVENTION

Flexographic printing plates are used for printing on soft and deformable surfaces such as plastic films, cardboard etc. Flexographic printing plate precursors typically contain a photopolymerizable layer comprising an elastomeric binder, a monomer and a photoinitiator. Conventionally, a photosensitive negative or positive of the desired image is used as a contact mask for the flood exposure of the photopolymerizable layer. In computer-to-plate technology, the conventional contact mask is replaced by a mask that is integrated within the printing plate precursor. Such an integrated mask can be provided by printing with an ink jet printer on the photopolymeric plate or by providing the polymeric plate with an ablatable image-recording layer that is substantially opaque to actinic radiation. This material may be called a direct-to-plate flexographic printing plate precursor.
Direct-to-plate flexographic printing plate precursors have been described in e.g. **WO-A-96 16356, EP-A-767 407, WO-A-94 03838** and **WO-A-94 03839.** These patents describe flexographic printing plate precursors comprising on a support a photopolymerizable layer and an IR-sensitive image-recording layer. Flexographic printing plates are produced by image-wise laser exposure inducing ablative removal to form a mask, UV flood exposure through the mask and development with an aqueous or organic solution. Such developing steps are time consuming and therefor expensive. In addition, potentially toxic waste products are produced.
In **EP-A-468 745, EP-A-468 667** and **US-P-5 215 859** conventional flexographic printing plate precursors are described comprising photopolymerizable polyurethane resins that can be developed thermally without requiring the use of aqueous or organic developing solutions as described in **EP-A-469 735.** This patent discloses a device to produce flexographic printing plates wherein the image-wise exposed photopolymerizable layer of the flexographic printing plate precursor is heated for a time and to a temperature sufficient to cause the unexposed areas to liquefy. Then the photopolymerizable layer is contacted with an absorbent material at a pressure sufficient for a portion of the liquefied areas to be absorbed. This step is repeated several times to clean up the unexposed areas.
However, when the above described prior art direct-to-plate flexographic printing plate precursors are applied in such a device problems arise since the integrated mask can not be thermally liquefied sufficiently. This prevents the removal of the integrated mask together with the unexposed, liquefied areas of the photopolymerisable layer.

SUMMARY OF THE INVENTION

It is an object of the present invention to provide a material for making a direct-to-plate flexographic printing plate precursor that can be developed without the use of aqueous or organic processing solutions.
It is a further object of the present invention to provide a method for making a direct-to-plate flexographic printing plate precursor.
The above mentioned objects are realised by the material and the method as defined by the independent claims.
A material for making a direct-to-plate flexographic printing plate precursor that can be developed thermally without the use of aqueous or organic processing solutions is obtained by providing an image recording layer and a photopolymerizable layer that each can be liquefied so that they can be penetrated to a depth of at least 5% at a temperature of 110°C by a ballpoint probe having a diameter of 3 mm, which is subjected to a force of 0.1N. Upon imaging and flood exposure the image-recording layer and the photopolymerizable layer are liquefied by heating. Thereafter the image-recording layer is removed together with the unexposed areas of the photopolymerizable layer by using an absorbent material.

DETAILED DESCRIPTION OF THE INVENTION

It has been found that, according to the present invention, a direct-to-plate flexographic printing plate precursor can be obtained that can be developed thermally without the use of aqueous or organic processing solutions. Hereto a thermoplastic binder with a glass transition temperature preferably below 65°C is incorporated in the image recording layer and the photopolymerizable layer so that each can be penetrated to a depth of at least 5% at a temperature of 110°C by a ballpoint probe. Penetration depths were measured with a Mettler TMA40 thermo mechanical analyser. Thereto a 100μm thick image recording layer or photopolymerizable layer was coated on a glass support and dried. A quartz ballpoint probe having a diameter of 3mm was positioned on the surface of the image recording layer or photopolymerizable layer. A force of 0.1N was applied onto the ballpoint probe while heating the material and the probe in an oven from 30°C to 160°C at a speed of 10°C/min. The penetration depth (%) is determined as follows at a temperature of 110°:

$$\text{Relative penetration depth} = [\text{absolute depth}(\mu m)/\text{absolute}$$

$$\text{thickness of the image recording layer }(\mu m)] X\ 100$$

Preferred thermoplastic binders for use in the image recording layer are polyesters, poly(meth)acrylates, polyvinylacetates or copolymers thereof or elastomeric polyurethane resins. Suitable commercially available binders are Dynapol S1404 (from Huls A.G.), Carboset 525 (from Goodrich), Mowilith CT5 (from Hoechst), Vitel VPE5545 (from Goodyear) and Vinnapas B100 (from Wacker Chemie).

According to the present invention the image recording layer is preferably a laser ablatable layer that further comprises a light absorbing compound. Preferred light absorbing compounds are IR-absorbing dyes such as phthalocyanines or derivatives, cyanine dyes, merocyanine dyes and polymethine dyes or inorganic pigments such as carbon black, graphite, iron oxide or chromium oxide. Preferably carbon black is used. Furthermore carbon black renders the ablatable layer opaque to UV radiation, so there is no need to add an additional UV-absorbing dye. It is particularly preferred to use fine-grained carbon black with a mean particle size below 30nm which is commercially available as Printex® U, Printex® L6, Specialschwarz 4 or Specialschwarz 250 (all trademarks from Degussa).

Suitable supports for the imaging material of the present invention are flexible but dimensionally stable materials such as films of polyethylene therephthalate, cellulose triacetate, polyethylene naphthalate, polybutylene terephthalate or polycarbonate that have a sufficiently high modulus. Also metal supports can be used.

A photopolymerizable layer containing an elastomeric binder is provided onto the support. A preferred elastomeric binder is a photopolymerizable polyurethane resin derived from polymer forming reactions of (a) 10-50% by weight of at least one diisocyanate, (b) 0.5-20% by weight of a first chain extension agent having at least two free hydrogen groups and having at least one ethylenically unsaturated addition polymerisable group per molecule (optionally, a second chain extension agent may be present having at least two free hydrogen groups (0.5-20% by weight)) and (c) 10-70% by weight of an organic polyol having a molecular weight of at least 500 and containing at least two free hydrogen groups per molecule. The polyurethane resins used in the present invention have a molecular weight of at least 10.000 and a glass transition temperature of less than 65°C. The polyurethane resins belong to a class of polymers known as segmented copolymers or multiphase polymers. The elastomeric properties of these polymers result from phase separation between so called 'hard' segment domains and 'soft' segment domains. The two phases are thought to exist as separate phases within the polymer. 25-70% of the segment domains are 'soft' segment domains. The photopolymerizable layer further comprises a free radical photoinitiator (0.5 to 8% by weight of the elastomer). Other additives such as dyes, pigments or fillers can be present.

Optionally a primer layer is provided between the support and the photopolymerizable layer. This layer preferably comprises aziridine functional compounds. The aziridine functional compounds are used in an amount of at least 10% by weight solids of the primer layer. The aziridine functional compounds may be diluted with solids that comprise inert compatible polymeric organic binders, coupling agents, particulates, comonomers, other priming agents and the like. The aziridine functional compound may also contain other functional groups. Preferably these groups are not reactive with the aziridine functionality under ambient conditions. Thus, for example, the aziridine-functional compound may also contain one or more hydroxyl groups. Specific examples of aziridine functional compounds can be found in **WO-A-92 21069.**

Furthermore according to the present invention an antistatic layer can be present between the photopolymerizable layer and the image recording layer. Preferably a vanadium oxide antistatic layer is applied as described in **EP-A-573 365.**

Optionally a cover layer can be applied on top of the image recording layer. Suitable cover layers comprise films of polyethylene terephthalate, cellulose triacetate, polypropylene, and polyethylene. Also resin coated paper or carriers coated with a release agent such as carnauba wax, organic silicones, tetrafluoroethylene telomers etc. can be used.

According to the method of the present invention, after optional removal of the cover layer the flexographic printing plate precursor is image-wise exposed to form a mask. Preferred devices used for image-wise exposure are Nd/YAG lasers (1064 nm) or diode lasers (e.g. 830 nm). After the image-wise exposure the material is subjected to flood exposure with UV-light through the mask. Subsequently the flexographic printing plate precursor is developed by contacting the image recording layer with an absorbent material while heating by convection, conduction or other heating methods to a temperature sufficiently high to liquefy the unexposed areas of the photopolymerizable layer and the mask. Hereby the unexposed areas of the photopolymerizable layer as well as the mask are thermally liquefied and transferred onto the absorbent material. Preferably the flexographic printing plate precursor is heated to a temperature between 50°C and 130°C. The absorbent material has preferably a melting or softening temperature higher than the melting temperature of the elastomeric polyurethane resin and the thermoplastic binder of the image recording layer. The absorbent material is selected from non-woven web materials, paper stocks, fibrous woven materials, open-celled foam materials, porous sheets or other sheet materials which contain , more or less, a substantial fraction of their included volume as void volume. Preferably non-woven web materials made from polyesters, nylon or other high temperature melting thermoplastic polymers are used. Suitable commercially available non-woven web materials are Cerex (James River Corporation) and Soft Wipers White cleaning cloth (nr. 010932 from EVI). In order to remove all the unexposed material together with the mask, the absorbent material is preferably contacted with the image recording layer at least three times. After separation of the absorbent material and cooling to room temperature, the flexographic printing plate can be mounted onto a printing press.

Examples

While the present invention will hereinafter be described in connection with preferred embodiments thereof, it will be understood that it is not intended to limit the invention to those embodiments.

Image recording layer

A laser recordable composition was prepared from a coating solution containing the following ingredients as listed in table 1:

Table 1:

| Coating composition (g) | | | | |
|---|---|---|---|---|
| Component | Sample | | | |
| | I | II | III | IV |
| Special Schwarz 250 (Degussa) (Carbon black pigment) | 3.42 | 3.42 | 3.42 | 3.42 |
| Dynapol S1404 (Hüls) (Thermoplastic binder) | 4.80 | / | / | / |
| Neocryl B723 (Zeneca Resins)(Thermoplastic binder) | / | 4.80 | / | / |
| Dynapol L912 (Hüls)(Thermoplastic binder) | / | / | 4.80 | / |
| Waloran E950 (Wolff Walrode)(Binder) | / | / | / | 4.80 |
| Solsperse 5000 (Zeneca Resins) (Dispersion agent) | 0.07 | 0.07 | 0.07 | 0.07 |
| Solsperse 28000 (Zenica Resins)(Dispersion agent) | 0.34 | 0.34 | 0.34 | 0.34 |
| Baysilon MA (Bayer) (Coating aid) | 0.10 | 0.10 | 0.10 | 0.10 |
| MEK/ethylacetate (1:1 v/v) | 90.9 | 90.9 | 90.9 | 90.9 |

These solution were coated onto a Persalic-LF-50 film (50μm PETP film from Perlen Converting coated on one side with a silicon release agent) by means of a 30 μm coating knife and dried for 2 min. at 45°C yielding an image recording layer with a dry coating weight of 2.7g/m$^2$ having an optical density in the UV region of >4.0.

Photopolymerizable layer

A photopolymerizable polyurethane elastomeric composition was prepared in a twin-screw extrusion reactor as follows:

I. A polyol mixture was prepared of the following components which were thoroughly mixed in a feed tank until homogeneous:

A. 286.1 parts (0.2861 moles) of a 1000 molecular weight poly 1,2-(butylene oxide) diol (Dow Chemical Co.);

B. 32.8 parts (0.3644 mole) of 1,4-butane diol (GAF Chemical Co.)
C. 10.7 parts (0.0669 mole) of 2-glycerol methacrylate (3M Co.);
D. 10.6 parts of diethoxy acetophenone (Irgacure-651,Ciba-Geigy Co.)
E. 0.1 part methylene blue
F. 0.06 part ferric chloride
G. 0.26 part dibutyl tin dilaurate

II. A precision flow metering system was utilised to meter the above polyol stream into the inlet port of a 64 mm twin-screw counter rotating extruder (Leistritz Co.) at a ratio of 62.47 parts by weight of polyol stream to 37.53 parts by weight 4,4-bis(isocyanato cyclohexyl)methane (Desmodur W TM , Mobay Chemical Co.). At this mass ratio, there was a slight equivalency excess of isocyanate moieties in the feed stream relative to hydroxyl moieties. The reaction temperature of the polymerising mass was maintained in the range of 150 to 170°C as polymerisation occurred in the extruder. Upon exiting from the extruder, the fully reacted curable elastomer composition was segregated into pellets having diameters of approximately 0.3 cm which were collected for further processing. The completeness of the polymerisation reaction was determined by monitoring the infrared spectrum of a cast film of the photopolymerizable elastomer product and determining the absorbance ratio of the -NCO absorption band (2250 cm-1) to the -CH2-absorption band (2950cm-1). A ratio of less than 0.2 indicated a complete reaction with only a slight excess of -NCO groups remaining.

The fully reacted photopolymerizable polyurethane elastomeric composition consisted of the following mole ratios of constituents:

| Component | Amount (Moles) |
|---|---|
| 4,4'-bis(isocyanato cyclohexyl)methane | 2.730 |
| 1,4 butane diol | 1.274 |
| 2-glycerol methacrylate | 0.234 |
| Poly 1,2(butyl oxide)diol | 1.000 |

The above polyurethane elastomeric composition was reextruded between a 175µm PET that has been coated with a tris-aziridine adhesive layer and the image recording layers provided on the Persalic-LF-50 film. This film now acts as cover film.

Image-wise exposure

The cover film was first removed from the image recording layer and then the flexographic printing plate precursor was image-wise exposed with a NdYLF laser (1064 nm) having a spot size of 18µm, at a pitch of 10µm and at a scan speed of 2m/s. The image plane power was set between 200 and 450 mW with intervals of 50 mW.

Preparation of the flexographic printing plate

After image-wise laser exposure the flexographic printing plate precursor was flood exposed through the thus formed mask with UV radiation (4000µW/cm$^2$) for 20 min. Then the flexographic printing plate precursor was developed using a Codor LPP 650 laminator at 120°C. Thereto the flexographic printing plate precursor was contacted with a Soft Wipers White cleaning cloth (nr. 010932 from EVI)and passed through the lamination rollers (speed 35cm/min). The cleaning cloth was replaced after each passage through the rollers and the optical density on the printing plate was measured (see results).

Results

Before development and after the first three cleaning cycles the optical density on the printing plate was measured (table 2).

Table 2

| | $D_{max}$ Cleaning cycles | | | | $\Delta D_{max}$ | Relative penetration depth (%) |
|---|---|---|---|---|---|---|
| Sample | Start | 1 | 2 | 3 | | |
| I | 3.01 | 1.23 | 0.97 | 0.82 | 2.19 | 80.3 |
| II | 3.68 | 2.54 | 2.26 | 1.86 | 1.82 | 9.0 |
| III | 2.20 | 2.20 | 2.13 | 2.13 | 0.07 | 4.1 |
| IV | 3.87 | 3.87 | 3.85 | 3.83 | 0.04 | 0.0 |

From the $\Delta D_{max}$ results in table 2 it may be concluded that after 3 cleaning cycles the image recording layer as well as the non-exposed areas of the photopolymerizable layer were removed for sample I and II. In sample III and IV the image recording layer was not removed after 3 cleaning cycles. Even after 8 cleaning cycles the image recording layer was not completely removed.

The flexographic printing plates obtained in sample I and II were mounted on a printing press and produced excellent prints.

**Claims**

1. Direct-to-plate flexographic printing plate precursor comprising in the order given, a flexible support, a photopolymerizable layer containing an elastomeric binder, an image recording layer comprising a thermoplastic binder and optionally a cover layer **characterised in that** said image recording layer and said photopolymerizable layer can each be liquefied so that they can be penetrated to a depth of at least 5% at a temperature of 110°C by a ballpoint probe having a diameter of 3 mm, which is subjected to a force of 0.1N.

2. Material according to claim 1 wherein said thermoplastic binder is a polyester, a poly(meth)acrylate, a polyvinylacetate or a copolymer thereof or an elastomeric polyurethane resin.

3. Material according to any of the preceding claims wherein said image recording layer is a laser ablatable layer.

4. Material according to any of the preceding claims wherein said elastomeric binder is a polyurethane resin.

5. Method for making a flexographic printing plate comprising the steps of:

   - providing a material according to any of the preceding claims;
   - optionally removing the cover layer;
   - image-wise exposing the image recording layer to form a mask;
   - flood exposing the photopolymerizable layer through the mask;
   - contacting the mask with an absorbent material
   - heating the photopolymerizable layer and the mask while in contact with the absorbent material thereby removing the unexposed areas of the photopolymerizable layer together with the mask.

**Patentansprüche**

1. Direktbeschreibbarer flexografischer Druckplattenvorläufer, der der Reihe nach einen biegsamen Träger, eine fotopolymerisierbare Schicht, die ein elastomeres Bindemittel enthält, eine Bildaufzeichnungsschicht, die ein thermoplastisches Bindemittel enthält, und gegebenenfalls eine Deckschicht enthält, **dadurch gekennzeichnet, daß** sowohl die Bildaufzeichnungsschicht als die fotopolymerisierbare Schicht dermaßen verflüssigbar sind, daß sie bei einer Temperatur von 110°C mit einer mit einer Kraft von 0,1 N benutzten Kugelschreibersonde mit einem Durchmesser von 3 mm bis eine Tiefe von zumindest 5% durchdringbar sind.

2. Material nach Anspruch 1, **dadurch gekennzeichnet, daß** das thermoplastische Bindemittel ein Polyester, ein Poly(meth)acrylat, ein Polyvinylacetat oder ein Copolymer derselben oder ein elastomeres Polyurethanharz ist.

**3.** Material nach einem der vorstehenden Ansprüche, **dadurch gekennzeichnet, daß** die Bildaufzeichnungsschicht eine laserablatierbare Schicht ist.

**4.** Material nach einem der vorstehenden Ansprüche, **dadurch gekennzeichnet, daß** das elastomere Bindemittel ein Polyurethanharz ist.

**5.** Ein durch die nachstehenden Schritte gekennzeichnetes Verfahren zur Herstellung einer flexografischen Druckplatte :

- Bereitstellen eines Materials nach einem der vorstehenden Ansprüche,
- gegebenenfalls das Entfernen der Deckschicht,
- bildmäßige Belichtung der Bildaufzeichnungsschicht zur Bildung einer Maske,
- Flutbelichtung der fotopolymerisierbaren Schicht durch die Maske hindurch,
- Inkontaktbringen der Maske mit einem absorbierenden Material,
- Erhitzung der fotopolymerisierbaren Schicht und der Maske in Kontakt mit dem absorbierenden Material, wodurch die unbelichteten Bereiche der fotopolymerisierbaren Schicht und die Maske zusammen entfernt werden.

**Revendications**

**1.** Un précurseur de plaque d'impression flexographique à impression directe comprenant, dans l'ordre donné, un support flexible, une couche photopolymérisable contenant un liant élastomère, une couche d'enregistrement d'image comprenant un liant thermoplastique et éventuellement une couche de recouvrement, **caractérisé en ce que** ladite couche d'enregistrement d'image et ladite couche photopolymérisable peuvent chacune être liquéfiée si bien qu'elles peuvent être pénétrées jusqu'à une profondeur d'au moins 5 % à une température de 110 °C par une sonde stylo possédant un diamètre de 3 mm qui est soumise à une force de 0,1 N.

**2.** Matériau selon la revendication 1, **caractérisé en ce que** ledit liant thermoplastique est un polyester, un poly (méth)acrylate, un poly(acétate de vinyle) ou un de leurs copolymères ou une résine de polyuréthane élastomère.

**3.** Matériau selon l'une quelconque des revendications précédentes, **caractérisé en ce que** ladite couche d'enregistrement d'image est une couche qui peut être ablatée par laser.

**4.** Matériau selon l'une quelconque des revendications précédentes, **caractérisé en ce que** ledit liant élastomère est une résine de polyuréthane.

**5.** Procédé pour faire une plaque d'impression flexographique, comprenant les phases consistant à:

- fournir un matériau selon l'une quelconque des revendications précédentes.
- éliminer éventuellement la couche de recouvrement;
- exposer sous forme d'image la couche d'enregistrement d'image pour former un masque;
- exposer intégralement la couche photopolymérisable à travers le masque;
- mettre le masque en contact avec un matériau absorbant;
- chauffer la couche photopolymérisable et le masque pendant qu'ils sont en contact avec le matériau absorbant, éliminant ainsi les zones non exposées de la couche photopolymérisable ensemble avec le masque.